# EUROPEAN PATENT APPLICATION

(11) **EP 4 163 983 A1**
(43) Date of publication of application: **12.04.2023**
(21) Application number: 20939025.1
(22) Date of filing: 28.09.2020
(51) Int. Cl.: H01L 31/0296, H01L 31/0445

(54) **HIGH-EFFICIENCY CADMIUM TELLURIDE THIN-FILM SOLAR CELL AND PREPARATION METHOD THEREFOR**

(30) Priority: 05.06.2020 CN 202010507161
(71) Applicant: China Triumph International Engineering Co., Ltd., Putuo Shanghai 200030 (CN)
(72) Inventor: PENG, Shou, Shanghai 200030 (CN); CHEN, Ying, Shanghai 200030 (CN); YIN, Xinjian, Shanghai 200030 (CN); ZHOU, Xianhua, Shanghai 200030 (CN); WEI, Mengnan, Shanghai 200030 (CN)
(74) Representative: Mittler, Andrea
(86) International application number: PCT/CN2020/118393
(87) International publication number: WO 2021/243896

(57) **Abstract**

Disclosed are a high-efficiency cadmium telluride thin-film solar cell and a preparation method therefor. The solar cell comprises a substrate layer, a window layer, a light-absorbing layer and a back electrode layer, which are sequentially arranged from bottom to top, wherein the window layer is made of magnesium-doped zinc oxide, the light-absorbing layer is an arsenic-doped tellurium-selenium-cadmium thin-film layer, and the back electrode layer is made of a composite metal material of molybdenum, aluminum and chromium. According to the present invention, the tellurium-selenium-cadmium thin-film layer is doped with a proper amount of As instead of Cu in an electric injection regeneration manner, so that the high p-type doping density is realized, Voc > 1V, a conversion efficiency > 23%, the conversion efficiency is high. The whole preparation process is simple to operate and easy to control.

## Description

### BACKGROUND OF THE INVENTION

### Field of the Invention

The invention relates to the technical field of thin-film solar cells, and more particularly, to a high-efficiency cadmium telluride thin-film solar cell and a preparation method therefor.

### Description of the Related Art

When compared with single crystaline silicon solar cells, cadmium telluride solar cells have advantages of easier manufacturing process, lower costs and light weight. The cadmium telluride thin-film solar cells are referred to as CdTe cells. CdTe cells are thin-film solar cells based on heterojunctions of p-type CdTe and n-type CdSe. Typical cadmium telluride thin-film solar cells consist of five layers: a back electrode layer, a back contact layer, a CdTe absorbing layer, a CdTe window layer, and a TCO layer. Costs for production of the cadmium telluride thin-film solar cells are much lower than those of solar cell with crystalline silicons and other materials. In addition, it is very consistent with the solar spectrum and can absorb more than 95% of sunlight. With extensive and in-depth applied researches, CdTe cells are not available for laboratory experiments only, but also for an industrial scale production in many counties around the world.

However, a bottleneck appears in improving the efficiency of the cadmium telluride thin-film solar cells. Since its it difficult to further improve Voc, and existing high-efficiency cells are all doped with copper, and introduction of copper will compromise the stability of the cells.

### SUMMARY OF THE INVENTION

Given that the foregoing problems exist in the prior art, the present invention provides a high-efficiency cadmium telluride thin-film solar cell and a preparation method therefor. In the present invention, the tellurium-selenium-cadmium thin-film layer is doped with a proper amount of As instead of Cu, so that the high p-type doping density is realized, Voc > 1V, a conversion efficiency > 23%, and the cadmium telluride cell has long-term efficient stability.

To achieve the above-mentioned purposes, the present invention provides the following technical solution:
In a first aspect of the invention, there is provided a high-efficiency cadmium telluride thin-film solar cell, wherein the solar cell comprises a substrate layer, a window layer, a light-absorbing layer and a back electrode layer, which are sequentially arranged from bottom to top;
wherein the window layer is made of a magnesium-doped zinc oxide, the light-absorbing layer is an arsenic-doped tellurium-selenium-cadmium thin-film layer, and the back electrode layer is made of a composite metal material of molybdenum, aluminum and chromium.

Preferably, the substrate layer is made of one of an indium-tin -oxide conductive film layer, a TiOz conductive film layer and an aluminium-doped zinc oxide conductive film layer.

Preferably, the window layer has a thickness of 40-70nm; the light-absorbing layer has a thickness of 2.0-4.0µm; and the back electrode layer has a thickness of 220-250nm.

Preferably, a molar percentage of magnesium in the magnesium-doped zinc oxide comprises is in a range from 0% to 8%; and a molar percentage of arsenic in the arsenic-doped tellurium-selenium-cadmium is in a range from 3% to 20%.

In a second aspect of the invention, there is provided a preparation method for the above-mentioned high-efficiency cadmium telluride thin-film solar cell, comprising the steps of:
Step S1, depositing the window layer on the substrate layer;
Step S2, depositing the light-absorbing layer on the window layer, performing an activation annealing on the light-absorbing layer by way of an activation annealing process;
Step S3, depositing the back electrode layer on the light-absorbing layer to obtain a cadmium telluride thin-film solar cell;
Step S4, etching and cleaning the solar cell obtained in Step S3 with hydrochloric acid at a mass concentration of 0.05-5%, then depositing a zinc telluride thin-film layer on the solar cell by magnetron sputtering, wherein the zinc telluride thin-film layer has a thickness of 20-80nm;
Step S5, first performing grooving and scribing, by laser 1, on the solar cell processed in Step S4 for segmenting components of the solar cell into about 200-300 units, and coating photoresist for development, filling the units subjected to the grooving and scribing process; then performing the grooving and scribing again, by laser 2, to groove and scribe 200-300 lines, depositing the back electrode layer after the completion of the grooving and scribing of the lines, then performing an activation annealing to the components for encapsulation of conventional components; and
Step S6, performing an electric injection activation of cadmium telluride on the components encapsulated in Step S5, and applying a certain bias voltage and current to terminals of the solar cell.

Preferably, the window layer is produced by deposition by magnetron sputtering, screen printing technique or radio frequency sputtering; the light-absorbing layer is produced by deposition by close-spaced sublimation, vapor transport deposition or electrochemical deposition; and the back electrode layer is produced by deposition by magnetron sputtering.

Preferably, in Step S2, a deposition process for the light-absorbing layer comprises a deposition of a cadmium selenide thin film, having a thickness of 100-1700nn by close-spaced sublimation, followed by a deposition of an arsenic-doped cadmium telluride thin film having a thickness of 1300-3900nm.

Preferably, a process for preparing the arsenic-doped cadmium telluride material comprises mixing a Cd₃As2 material with a purity greater than 5N and a CdTe material with a purity greater than 5N to obtain a mixture, and grinding the mixture; a concentration of arsenic in the mixture is in a range from 1×10¹⁵cm⁻³ to 1×10²²cm⁻³.

Preferably, in Step S2, the activation annealing process is carried out at a temperature of 350-600° C for a period of 5-40min; in Step 5, the activation annealing process is carried out at a temperature of 150-280° C for a period of 5-30min.

Preferably, in Step S6, the electric injection is carried out at a temperature of 80-150° C for a period of 3-15min; a range of the bias voltage is Voc ±15%, and a range of the current- is 1-3 times Jsc.

By adopting the above-mentioned technical solutions, the present invention has the following beneficial effects:
1. the window layer in the cadmium telluride thin-film solar cell is made of magnesium-doped zinc oxide, the light-absorbing layer is made of arsenic-doped tellurium-selenium-cadmium, the tellurium-selenium-cadmium thin-film layer is doped with a proper amount of As instead of Cu, so that the high p-type doping density is realized, Voc > 1V, a conversion efficiency > 23%, the conversion efficiency is high.
2. In the present invention, a performance of a cadmium telluride cell is improved by means of an electric injection regeneration method; in addition, the cadmium telluride cell prepared by the method provided in the present invention has excellent initial performance, and the cadmium telluride cell has long-term efficient stability. The whole preparation process is simple to operate and easy to control.

### BRIEF DESCRIPTION OF THE DRAWINGS

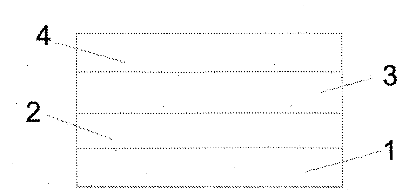

Figure 1 is a schematic diagram showing a structure of a high-efficiency cadmium telluride thin-film solar cell in the present invention;

### Reference numerals in all the figures:

1-substrate layer; 2-window layer; 3-light-absorbing layer; 4- back electrode layer.

### DETAILED DESCRIPTION

The present invention will be described hereinafter with reference to the accompanying drawings and particular embodiments, but the invention is not limited thereto.

Notably, the embodiments set forth in the present invention and features of the embodiments may be combined in any suitable manner.

As shown in Figure 1, the invention provides a high-efficiency cadmium telluride thin-film solar cell, wherein the solar cell comprises a substrate layer 1, a window layer 2, a light-absorbing layer 3 and a back electrode layer 4, which are sequentially arranged from bottom to top; wherein the window layer 2 is made of a magnesium-doped zinc oxide, the light-absorbing layer 3 is an arsenic-doped tellurium-selenium-cadmium thin-film layer, and the back electrode layer 4 is made of a composite metal material of molybdenum, aluminum and chromium.

As a preferred embodiment of the invention, the substrate layer 1 is made of one of an indium-tin -oxide conductive film layer, a TiOz conductive film layer and an aluminium-doped zinc oxide conductive film layer.

As a preferred embodiment of the invention, the window layer 2 has a thickness of 40-70nm; the light-absorbing layer 3 has a thickness of 2.0-4.0µm; and the back electrode layer 4 has a thickness of 220-250nm.

As a preferred embodiment of the invention, a molar percentage of magnesium in the magnesium-doped zinc oxide comprises is in a range from 0% to 8%; and a molar percentage of arsenic in the arsenic-doped tellurium-selenium-cadmium is in a range from 3% to 20%.
a preparation method for the above-mentioned high-efficiency cadmium telluride thin-film solar cell, comprising the steps of:
Step S1, depositing the window layer 2 on the substrate layer 1;
Step S2, depositing the light-absorbing layer 3 on the window layer 2, performing an activation annealing on the light-absorbing layer 3 by way of an activation annealing process;
Step S3, depositing the back electrode layer 4 on the light-absorbing layer 3 to obtain a cadmium telluride thin-film solar cell;
Step S4, etching and cleaning the solar cell obtained in Step S3 with hydrochloric acid at a mass concentration of 0.05-5%, then depositing a zinc telluride thin-film layer on the solar cell by magnetron sputtering, wherein the zinc telluride thin-film layer has a thickness of 20-80nm;
Step S5, first performing grooving and scribing, by laser 1, on the solar cell processed in Step S4 for segmenting components of the solar cell into about 200-300 units, and coating photoresist for development, filling the units subjected to the grooving and scribing process; then performing the grooving and scribing again, by laser 2, to groove and scribe 200-300 lines, depositing the back electrode layer 4 after the completion of the grooving and scribing of the lines, then performing an activation annealing to the components for encapsulation of conventional components; and
Step S6, performing an electric injection activation of cadmium telluride on the components encapsulated in Step S5, and applying a certain bias voltage and current to terminals of the solar cell.

As a preferred embodiment of the invention, the window layer 2 is produced by deposition by magnetron sputtering, screen printing technique or radio frequency sputtering; the light-absorbing layer 3 is produced by deposition by close-spaced sublimation, vapor transport deposition or electrochemical deposition; and the back electrode layer 4 is produced by deposition by magnetron sputtering.

As a preferred embodiment of the invention, in Step S2, a deposition process for the light-absorbing layer 3 comprises a deposition of a cadmium selenide thin film, having a thickness of 100-1700nn by close-spaced sublimation, followed by a deposition of an arsenic-doped cadmium telluride thin film having a thickness of 1300-3900nm.

As a preferred embodiment of the invention, a process for preparing the arsenic-doped cadmium telluride material comprises mixing a Cd₃As2 material with a purity greater than 5N and a CdTe material with a purity greater than 5N to obtain a mixture, and grinding the mixture under vacuum conditions; a concentration of arsenic in the mixture is in a range from 1×10¹⁵cm⁻³ to 1×10²²cm⁻³.

As a preferred embodiment of the invention, in Step S2, the activation annealing process is carried out at a temperature of 350-600° C for a period of 5-40min; in Step 5, the activation annealing process is carried out at a temperature of 150-280° C for a period of 5-30min.

As a preferred embodiment of the invention, in Step S6, the electric injection is carried out at a temperature of 80-150° C for a period of 3-15min; a range of the bias voltage is Voc ±15%, and a range of the current is 1-3 times Jsc.

### Application Examples

The solar cell of the present invention is compared with the prior art in all aspects, and the results are shown in Table 1:

**Table 1**

| Doping factor | Jsc (mA/cm²) | Voc (mV) | FF (%) | Eff (%) |
|---|---|---|---|---|
| N/A | 25.8 | 759 | 33.1 | 6.48 |
| Copper-doped | 26.5 | 788 | 67.5 | 14.10 |
| Arsenic-doped | 26.8 | 1000 | 76.5 | 16.79 |

It is clear from data in Table 1 that the tellurium-selenium-cadmium thin-film layer is doped with a proper amount of As instead of Cu, so that the high p-type doping density is realized, Voc > 1V, a conversion efficiency > 23%, the conversion efficiency is high.

The above descriptions are only the preferred embodiments of the invention, not thus limiting the embodiments and scope of the invention. Those skilled in the art should be able to realize that the schemes obtained from the content of specification and drawings of the invention are within the scope of the invention.

## Claims

1. A high-efficiency cadmium telluride thin-film solar cell, wherein the solar cell comprises a substrate layer (1), a window layer (2), a light-absorbing layer (3) and a back electrode layer (4) which are sequentially arranged from bottom to top;
wherein the window layer (2) is made of a magnesium-doped zinc oxide, the light-absorbing layer (3) is an arsenic-doped tellurium-selenium-cadmium thin-film layer, and the back electrode layer (4) is made of a composite metal material of molybdenum, aluminum and chromium.

2. The high-efficiency cadmium telluride thin-film solar cell of claim 1, wherein the substrate layer (1) is made of one of an indium-tin -oxide conductive film layer, a TiOz conductive film layer and an aluminium-doped zinc oxide conductive film layer.

3. The high-efficiency cadmium telluride thin-film solar cell of claim 1, wherein the window layer (2) has a thickness of 40-70nm; the light-absorbing layer (3) has a thickness of 2.0-4.0µm; and the back electrode layer has a thickness of 220-250nm.

4. The high-efficiency cadmium telluride thin-film solar cell of claim 1, wherein a molar percentage of magnesium in the magnesium-doped zinc oxide comprises is in a range from 0% to 8%; and a molar percentage of arsenic in the arsenic-doped tellurium-selenium-cadmium is in a range from 3% to 20%.

5. A preparation method for the high-efficiency cadmium telluride thin-film solar cell of any one of claims 1-4, comprising the steps of:
Step S1, depositing the window layer (2) on the substrate layer (1);
Step S2, depositing the light-absorbing layer (3) on the window layer (2), performing an activation annealing on the light-absorbing layer (3) by way of an activation annealing process;
Step S3, depositing the back electrode layer (4) on the light-absorbing layer (3) to obtain a cadmium telluride thin-film solar cell;
Step S4, etching and cleaning the solar cell obtained in Step S3 with hydrochloric acid at a mass concentration of 0.05-5%, then depositing a zinc telluride thin-film layer on the solar cell by magnetron sputtering, wherein the zinc telluride thin-film layer has a thickness of 20-80nm;
Step S5, first performing grooving and scribing, by laser 1, on the solar cell processed in Step S4 for segmenting components of the solar cell into about 200-300 units, and coating photoresist for development, filling the units subjected to the grooving and scribing process; then performing the grooving and scribing again, by laser 2, to groove and scribe 200-300 lines, depositing the back electrode layer 4 (4) after the completion of the grooving and scribing of the lines, then performing an activation annealing to the components for encapsulation of conventional components; and
Step S6, performing an electric injection activation of cadmium telluride on the components encapsulated in Step S5, and applying a certain bias voltage and current to terminals of the solar cell.

6. The preparation method for the high-efficiency cadmium telluride thin-film solar cell of claim 5, wherein the window layer (2) is produced by deposition by magnetron sputtering, screen printing technique or radio frequency sputtering; the light-absorbing layer (3) is produced by deposition by close-spaced sublimation, vapor transport deposition or electrochemical deposition; and the back electrode layer (4) is produced by deposition by magnetron sputtering.

7. The preparation method for the high-efficiency cadmium telluride thin-film solar cell of claim 6, wherein in Step S2, a deposition process for the light-absorbing layer (3) comprises a deposition of a cadmium selenide thin film, having a thickness of 100-1700nn by close-spaced sublimation, followed by a deposition of an arsenic-doped cadmium telluride thin film having a thickness of 1300-3900nm.

8. The preparation method for the high-efficiency cadmium telluride thin-film solar cell of claim 7, wherein a process for preparing the arsenic-doped cadmium telluride material comprises mixing a Cd₃As2 material with a purity greater than 5N and a CdTe material with a purity greater than 5N to obtain a mixture, and grinding the mixture; a concentration of arsenic in the mixture is in a range from 1×10¹⁵cm⁻³ to 1×10²²cm⁻³.

9. The preparation method for the high-efficiency cadmium telluride thin-film solar cell of claim 5, wherein in Step S2, the activation annealing process is carried out at a temperature of 350-600° C for a period of 5-40min; in Step 5, the activation annealing process is carried out at a temperature of 150-280° C for a period of 5-30min.

10. The preparation method for the high-efficiency cadmium telluride thin-film solar cell of claim 5, wherein in Step S6, the electric injection is carried out at a temperature of 80-150° C for a period of 3-15min; a range of the bias voltage is Voc ±15%, and a range of the current is 1-3 times Jsc.
